# EUROPEAN PATENT APPLICATION

(11) **EP 4 776 450 A1**
(43) Date of publication of application: **15.07.2026**
(21) Application number: 25151345.3
(22) Date of filing: 10.01.2025
(51) Int. Cl.: H02B 13/035

(54) **SYSTEM FOR A GAS-INSULATED SWITCHGEAR, SWITCHGEAR, SUBSTATION, AND USE**

(71) Applicant: Hitachi Energy Ltd, 8050 Zürich (CH)
(72) Inventor: Pfeiffer, Guido, 64285 Darmstadt (DE)
(74) Representative: Michalski Hüttermann & Partner mbB

(57) **Abstract**

The invention relates to a system (20) for a gas-insulated switchgear (2), comprising
a housing (30) with a flange (32) to be coupled to an electrical component (3), e.g. a disconnector/earthing switch, of the gas-insulated switchgear (2);
a low-power instrument transformer (40) arranged in the housing (30) and configured for conducting current and voltage measurements; and
a cable end module (50) arranged in the housing (30) and configured for receiving at least one power line (100) to be electrically connected to the electrical component (3) through the flange (32).

## Description

### Technical Field

The invention relates to a system for a gas-insulated switchgear. The invention further relates to a gas-insulated switchgear with a system, to a substation with a gas-insulated switchgear, and to a use of a system.

### Background Art

Systems for gas-insulated switchgear, particularly substations, remain an area of interest. Some existing systems have various shortcomings, drawbacks, and disadvantages. For example, in some systems for gas-insulated switchgear, improvements in their construction, space consumption, and/or electrical properties for a better reliability may be made. In addition, costs need to be optimized. Accordingly, there remains a need for further contributions in this area of technology.

### Summary of invention

It is therefore an object of the invention to provide novel and/or alternative solutions with respect to systems for gas-insulated switchgear that provide improvements in space consumption, electrical properties, cost of production, and cost of operation. Particularly it is an object to avoid or reduce disadvantages of known solutions.

The invention is defined by the features of the independent claims. Preferred implementations are detailed in the dependent claims, the description, and the figures.

The object is particularly solved by a system for a gas-insulated switchgear, particularly for a substation with a gas-insulated switchgear, the system comprising
a housing with a flange coupled or to be coupled, at least indirectly e.g. via a connector, to an electrical component of the gas-insulated switchgear, wherein the electrical component may be a disconnector/earthing switch, particularly of the substation;
a low-power instrument transformer, LPIT for short, arranged in the housing and configured for conducting current and voltage measurements, e.g. the low-power instrument transformer including at least one conductive section to be electrically connected or connected through the flange to the electrical component and configured for conducting current and voltage measurements on the at least one conductive section; and
a cable end module or cable end unit, CEU for short, arranged in the housing and configured for receiving at least one power line to be electrically connected, e.g. at least indirectly, to the gas-insulated switchgear or the electrical component especially through the flange, e.g. the cable end module configured for connecting the at least one power line to the low-power instrument transformer, particularly to the at least one conductive section and/or to the electrical component through or via the low-power instrument transformer.

In other words, particularly, the object is solved by a system, e.g. an apparatus or a device, for a gas-insulated switchgear, particularly for a substation with a gas-insulated switchgear, the system comprising
a cable end module configured for receiving at least one power line and connecting, e.g. at least indirectly, the at least one power line to the gas-insulated switchgear, e.g. an electrical component such as a disconnector/earthing switch of the gas-insulated switchgear or the substation;
a low-power instrument transformer configured for conducting current and voltage measurements, e.g. at least indirectly, on the at least one power line, which at least one power line can be received by the cable end module; and/or
a housing with a flange coupled or to be coupled to an/the electrical component of the gas-insulated switchgear or the substation, such as the disconnector/earthing switch of the gas-insulated switchgear, particularly the substation, e.g. the housing configured for housing the cable end module and the low-power instrument transformer.

It is particularly provided that the cable end module and the low-power instrument transformer are arranged in the housing, and that the at least one power line is connected, e.g. at least indirectly, through or via the flange to the electrical component, such as the disconnector/earthing switch. Thus, the cable end module and the low-power instrument transformer are housed or held in a common housing, i.e. are integrated with one another. Thereby, a single LPIT might be sufficient instead of a current transformer and a voltage transformer or two LPITs, all of which involve at least two housings.

Particularly, the invention provides a device that integrates a low-power instrument transformer (e.g. known as LPIT) and a cable end module or (e.g. known as cable end module or CEU) in a functional unit. The device can receive cable ends and provide a gas-insulated connection to an electrical component, such as a disconnector/earthing switch, among the functionality of an LPIT.

The invention not only has the idea to put an LPIT and a CEU on one side of the gas-insulated switchgear or an electrical component thereof in series, but also has the idea integrate the LPIT and the CEU in one housing such that a size and weight of a switchgear can be reduced. Thereby, assembly can be made easier, especially in case of offshore applications, where transportation is made easier when at least one of weight and size are reduced. Thus, cost can be reduced.

Particularly, the invention seeks to beneficially avoid that the electrical component, e.g. disconnector/earthing switch, needs to be coupled to more than one LPIT. Typically, with the invention no further LPIT need to be adopted in a switchgear in order to monitor voltage and current.

The invention furthermore seeks to beneficially avoid that individual current and voltage transformers need to be provided in a gas-insulated switchgear or a substation. Rather, the LPIT or a single LPIT seeks to replace such transformers.

A gas-insulated switchgear, GIS for short, generally relates to an electrical system that involves insulating gas and various electrical devices to be operated in the insulating gas. For example, the switchgear may include, not limited to, one or more of a disconnector/earthing switch, low-power instrument transformer, current transformer, voltage transformer, circuit-breaker, disconnector, control unit, and/or the like, herein particularly referred to as electrical components.

A/the 'disconnector/earthing switch', e.g. 'disconnector and/or earthing switch', includes a switch. The switch is typically configured for disconnecting and/or earthing. The switch typically includes at least one of a disconnector/disconnecting switch and an earthing switch, e.g. a combination of disconnector and earthing switch.

An/the electrical component typically includes a housing or casing of the electrical component, the housing or casing including a flange to be connectable to the flange of the housing of the system. The gas-insulated switchgear may be configured to de-energize equipment and/or to clear faults downstream. The gas-insulated switchgear may be a component of a substation. The gas-insulated switchgear may be configured as a low-voltage, medium-voltage, or high-voltage switchgear.

A substation may include, not limited to, at least one gas-insulated switchgear and at least one power transformer configured to change a voltage level.

The at least one power line, particularly each one of the at least one power line, may include an isolated conductor for transmission of electrical power. The at least one power line may include at least one cable, which at least one cable may have an isolating cable sleeve surrounding a metallic cable core. The at least one power line may be contained by the substation or connected to the substation.

The housing may comprise an interior and an exterior. The housing may include a tube-like shape. The interior may have a substantially cylindrical shape. The housing may include the flange, particularly two flanges on opposite sides of the housing. The housing may extend along an axial length, particularly between the two flanges. The housing may comprise or consist of a metal, e.g. an aluminum alloy or a steel. The flange may be substantially round. The flange may include mounting holes for bolts. The flange may have a flange face extending along a plane, the flange face configured for mating with another flange face, e.g. of a connector for mechanical connection. The two flanges may include parallel flange faces facing away from one another. The housing may be configured to be filled in the interior with insulating gas, especially at ambient pressure or at a pressure different to the exterior, e.g. underpressure or overpressure. The housing may be configured to surround the low-power instrument transformer and the cable end module, each at least in a section, and particularly between two flanges of the housing. The housing may include or consist of a monolithic structure that forms the flange or the two flanges.

The flange can be coupled, directly or indirectly, to an electrical component of a gas-insulated switchgear or a substation, e.g. to a disconnector/earthing switch of the gas-insulated switchgear or the substation. The flange may include or realize a sealing. The flange face may be arranged on another flange face in a fluid tight or gas tight manner, e.g. by placing the sealing or a sealing means between the flange faces and/or by bolting the flanges.

The low-power instrument transformer, LPIT for short, may be arranged at least in a section or in its entirety in the housing or in the interior of the housing. The housing may accommodate the LPIT at least in part or in a section. The LPIT can conduct at least one of a current measurement and a voltage measurement, particularly both. For example, such measurement(s) can be conducted at least indirectly on the at least one power line received by the cable end module. The LPIT may be arranged at least substantially between the cable end module and the flange. The LPIT can replace a voltage transformer and a current transformer in terms of function. The LPIT may include Rogowski coils as measurement coils to measure the current. The primary voltage may be measured by capacitive voltage sensors of the LPIT. The measured values can be digitally processed by secondary converters of the LPIT and may be sent to a merging unit of the LPIT. The merging unit may provide the values according to IEC 61850-9-2 LE to protection, control and revenue metering equipment.

The LPIT may be configured for a rated voltage of up to 170 kV, or up to 300 kV, or up to 550 kV. The LPIT may be configured for a rated current of up to 3150 A, or up to 4000 A, or up to 6300 A.

The system, particularly the LPIT, may include at least one conductive section to be electrically connected or connected to the electrical component, e.g. through the flange. On another side, the at least one conductive section may be, directly or indirectly, connected to the at least one power line. Substantially the entire current flowing through the at least one conductive section can be measured with the LPIT. The at least one conductive section may be connected in series between the at least one power line and the electrical component. A voltage of the respective power line in respect to ground, in respect to the housing, and/or in respect to another power line may be measured by means of the LPIT. As a result, the LPIT can be configured for conducting current and voltage measurements on the at least one power line or on the at least one conductive section.

The cable end module, also known as cable sealing end or cable end unit or CEU, is at least in part or in a section arranged in the housing. The housing typically accommodates the cable end module at least in a substantial part or in its entirety. The cable end module may provide that the at least power line is introduced into the housing, particularly in a fluid tight or gas tight manner. The cable end module may provide a point of entry for the at least one power line to be connected, e.g. at least indirectly or via the LPIT, to the gas-insulated switchgear, particularly through or via the flange of the housing. The system, the cable end module, the gas-insulated switchgear, or the substation, may be configured to be connected to a gas-insulated line, GIL for short, particularly in a fluid tight or gas tight manner. For example, the cable end module may receive the power line(s) of a GIL. The cable end module can connect the at least one power line to the at least one conductive section for the purpose of transmission of electricity. The cable end module may also provide a mechanical connection of the at least one power line to the system such that forces can be transmitted without interrupting or affecting the electrical connection.

The gas-insulated switchgear is preferably configured for medium and/or high voltage switching applications, e.g. configured as a medium voltage or high voltage switchgear. The switchgear, particularly its circuit-breaker, may be used to interrupt the nominal current and the current caused by an electrical fault. The switchgear, particularly its circuit-breaker, may have to be capable of carrying high nominal currents of 3000 A to 6300 A and/or switching very high short-circuit currents of 31.5 kA to 80 kA particularly at high voltages of 72.5 kV, particularly up to 1200 kV. The term medium voltage may refer to a voltage from 1 kV to 72.5 kV, and the term high voltage to a voltage greater than 72.5 kV. The term high voltage means preferably a voltage above 12 kV or 36 kV or 72 kV or 1100 kV. A high voltage preferably relates to nominal voltages in the range from above 12 kV, 36 kV or 72 kV to 550 kV or 1100 kV, like 145 kV, 245 kV or 420 kV, or more. The term medium voltage means preferably a voltage above 1 kV or 12 kV or 36 kV. A medium voltage preferably relates to nominal voltages in the range from above 1 kV, 12 kV or 36 kV to 72 kV, like 5 kV, 10 kV, 25 kV or 70 kV.

The system, the switchgear and/or the substation may be configured to contain insulating gas. The insulating gas may comprise CO2, O2, N2, C4FN, SF6 and/or CF4, particularly mixtures thereof, and/or comprises an organic fluorine compound selected from the group consisting of fluoroethers (especially hydrofluoromonoethers), fluoroamines, fluororings Ethylene oxide, fluoroketone (especially perfluoroketone), fluoroolefin (especially hydrofluoroolefin), fluoronitrile (especially perfluoronitrile), and mixtures of the above compounds (especially in mixtures with background gases). The insulating gas and/or a dielectric insulation medium can be any suitable gas that enables to adequately extinguish an electric arc formed between contact elements during a current interruption operation, such as, but not limited to, an inert gas as, for example, carbon dioxide CO2. The insulating gas may be based on CO2, i.e. may include CO2 and/oder on further gas components, such as CF4, O2, N2, SF6 and/or C4FN. Optionally, the insulating gas can be at least substantially free of SF6 or not contain it. Specifically, the insulating gas used can any dielectric insulation medium and/or insulating gas, may it be gaseous and/or liquid, and in particular can be a dielectric gas or arc quenching gas. Such insulating gas can for example encompass media comprising an organofluorine compound, such organofluorine compound being selected from the group consisting of: a fluoroether, an oxirane, a fluoroamine, a fluoroketone, a fluoroolefin, a fluoronitrile, and mixtures and/or decomposition products thereof. The insulating gas can be selected from the group consisting of: a hydrofluoroether, a perfluoroketone, a hydrofluoroolefin, a perfluoronitrile, and mixtures thereof.

The term `coupled', 'coupling', 'couple', 'connected', 'connect', 'connecting', or the like typically relates to at least one of an electrical connection/link or mechanical connection/link, particularly to both.

The effects and advantages named herein may be improved further by adoption of preferred features or a combination thereof. The features named in the implementations may be individually combined with each other or considered alone.

It is noted that same names for features are meant to stand for same features as mentioned in the claims and throughout the description. This is particularly mentioned with respect to some features being referred to with indefinite articles despite having possibly being introduced in a preceding section. Accordingly, with matching feature names in cases with for example two or more indefinite articles of the feature names, the skilled person may adopt the corresponding description in each case.

The system, particularly the low-power instrument transformer, can include (the) at least one conductive section. The at least one conductive section may extend inside the housing, e.g. in the interior of the housing. The at least one conductive section is particularly provided to be electrically connected through the flange to the gas-insulated switchgear, e.g. the electrical component, e.g. directly or indirectly. The at least one conductive section may at least substantially and/or sectionally extend along a first direction. The at least one conductive section may extend substantially along a direction along which the at least one power line may be received in the cable end module. The first direction may extend through openings of flanges, particularly the two flanges, of the housing. The first direction may be a vertical direction. The first direction may point towards the electrical component.

Typically, the low-power instrument transformer comprises at least one measurement coil, particularly one or more Rogowski coils, typically surrounding the at least one conductive section. The at least one measurement coil is particularly arranged sectionally or entirely inside the housing, e.g. adjacent to or above the cable end module. The at least one measurement coil may surround the at least one conductive section substantially in a plane perpendicular to the first direction and/or in parallel to the flange face. A radial distance or radial gap between the at least one measurement coil and the at least one conductive section may be substantially equal across the circumference of the at least one conductive section. In order to compensate for thermal expansion of the at least one conductive section and to provide valid measurements, the at least one measurement coil may surround the at least one conductive section at least substantially in the middle of the at least one conductive section along the first direction. For example, in the first direction or the axial direction, the at least one conductive section may project from the at least one measurement coil on both sides substantially equidistantly, e.g. by up to 20% difference in length comparing the sides.

The cable end module may be configured to connect or may connect the at least one power line to the at least one conductive section. The cable end module may comprise at least one isolating body which at least one isolating body may be coupled to the housing, may be arranged to be in line on a first end with the at least one conductive section, and/or may be configured to provide a receptacle, e.g. opposite the first end, for the at least one power line. The at least one isolating body may be made from an electrically insulating material, such as a polymer compound and/or ceramics, and/or may be bolted and/or attached to the housing, e.g. to a cover member of the housing. The at least one isolating body may at least substantially extend along the first direction and/or point towards the at least one conductive section. The at least one isolating body may be open on one side in order to receive the at least one power line. The at least one isolating body may be shaped to taper from one side towards the other side and/or towards the at least one conductive section.

The flange may at least substantially extend along a horizontal plane and/or the flange face may be arranged at least substantially horizontally, particularly obliquely or perpendicularly with respect to the first direction or vertical direction. The cable end module, particularly the at least one isolating body, may be configured to receive the at least one power line a/the vertical direction and/or in the first direction. For example, the cable end module may receive the at least one power line on an underside or bottom side, e.g. on a side opposite the flange and/or through a/the second flange of the housing.

Particularly, the housing exhibits a cable receptacle side. The cable receptacle side may provide access to the cable end module, particularly to the receptacle, for connecting the at least one power line, e.g. with respect to mechanical connection to the system and/or to electrical connection to the at least one conductive section. The cable receptacle side may include an opening and/or the receptacle. The cable receptacle side may be on a side of the housing opposite the flange. The cable receptacle side may have a further flange to be closed or closed by a/the cover member of the housing, particularly in a fluid-tight or gas-tight manner. The further flange may be opposite the flange. The further flange may have (the) another flange face and/or may be the second flange.

The cover member may be configured to close the housing, particularly the further flange, particularly on a the cable receptacle side. The cover member may have at least one recess or opening through which the cable end module, particularly an/the at least one isolating body, can be accessible, e.g. for receiving and/or electrically connecting the at least one power line. The at least one isolating body may project through the at least one recess of the cover member. The at least one isolating body may be connected to the cover member, e.g. bolted thereto. The at least one isolating body may be connected in a fluid-tight or gas-tight manner to the cover member.

The system may have a connector for mechanical connection. The connector may provide or may be configured to provide a mechanical connection between the housing and the electrical component, e.g. the disconnector/earthing switch. The connector may be directly coupled to the flange, e.g. on one side of the connector. The connector may be configured to be directly coupled or directly coupled to the electrical component, e.g. on another side of the connector opposite the one side. The connector may have two opposite flanges. The connector may taper in diameter in the course from the side coupled to the flange to the side to be directly coupled to the electrical component and/or along the first direction. The connector may provide that a relatively larger diameter of the housing can be coupled to a relatively smaller diameter of the electrical component, while assuring the electrical coupling simultaneously. The connector may include that the interior of the housing is shut in a fluid tight or gas tight manner relative to the electrical component. The connector may close the flange in a fluid tight or gas tight manner, while the connector may however provide electrical connection. For example, at least one further conductive section may be provided in the connector.

The at least one conductive section may be, at least in a section, a hollow cylinder. The hollow cylinder may have a substantially cylindrical outside and/or a substantially cylindrical inside. The wall thickness of the hollow cylinder may be substantially constant along its extension or along the first direction. On a side facing towards the electrical component, the at least one conductive section may have a particularly flat face end to be mechanically coupled, e.g. bolted or the like, in an electrically conductive manner to a flat face end of at least one further conductive section.

The at least one conductive section, and optionally (the) at least one further conductive section of the system connected to the at least one conductive section, may be arranged for electrical connection of the at least one power line to the electrical component, e.g. the disconnector/earthing switch. For example, the at least one conductive section may be connected to at least one further conductive section, e.g. two further conductive sections, to be connected to the electrical component. In other words, one or more conductive sections arranged at least in a section in the housing and arranged in series may electrically connect the at least one power line to the electrical component. Thus, the power line can be connected indirectly to the electrical component via conductive sections. Thereby, the passage for voltage and current can be defined specifically to provide valid measurements, resistance can be optimized, repairability can be improved, and/or mechanical adaptability can be enhanced.

It may be provided that the at least one further conductive section and the at least one conductive section are coupled, particularly screwed, directly together, wherein screws or bolts may be screwed substantially along the first direction. For electrical connection, particularly flat face ends may be provided for mating with one another. Mating faces provided to conduct electricity may be arranged obliquely or at least substantially perpendicular to the flow of current, minimizing electrical resistance and providing that surfaces can be cleaned or polished easily before coupling/connecting.

The at least one conductive section and/or the at least one further conductive section may comprise or at least substantially consist of metal, particularly an aluminum alloy or aluminum or a copper alloy or copper, and/or may be coated, e.g. with silver or gold or another suitable material. For example, aluminum provides a good compromise of electrical conductivity and cost. Copper provides very good electrical conductivity.

The system may be configured as a three-pole system with the at least one power line comprising three power lines each corresponding to one of the three poles. Thus, three of the at least one conductive sections may be configured to be or connected individually to the electrical component, forwarding the potential or current of the respective three power lines.

The object is further solved by a gas-insulated switchgear comprising a/the system, e.g. the system coupled to an electrical component, e.g. a disconnector/earthing switch, of the switchgear. The switchgear may include a baseframe or base holding components of the switchgear, e.g. a circuit-breaker and others. The at least one power line may extend substantially vertically through the base to be received by the system and/or end therein. The switchgear may not have a current transformer. The switchgear may not have a voltage transformer. Aside from that of the system, the switchgear may not have a low-power instrument transformer. The system may be directly coupled to the electrical component.

The object is further solved by a substation comprising a/the gas-insulated switchgear and typically a power transformer.

The object is further solved by a use of a/the system, of a/the gas-insulated switchgear, or of a/the substation for or in an offshore windmill park. The offshore windmill park may include windmills configured to generate electricity based on wind power. The generated electricity may be forwarded to a substation of the offshore windmill park, e.g. as a hub receiving the generated electricity from a plurality of windmills. The system may be used in the substation, particularly in a gas-insulated switchgear thereof, in order to connect the power lines to an electrical component, such as a disconnector/earthing switch. The power lines may run vertically to be received in the cable end module of the system substantially vertically. The system enables that the power lines can be received and current and voltage can be measured on a relatively small space.

The term 'or' may be replaced by 'and/or' throughout the present disclosure. As such, where 'or' is used, it is not necessarily meant that merely alternatives are named.

### Brief description of drawings

These and other aspects of the invention will be apparent from and elucidated with reference to the implementations described hereinafter.

In the drawings:
- Fig. 1: shows a substation with a gas-insulated switchgear and a system;
- Fig. 2: shows a substation with a gas-insulated switchgear and a system;
- Fig. 3: shows a system for a gas-insulated switchgear; and
- Fig. 4: shows parts of a low-power instrument transformer of the system of Fig. 3.

### Description of implementations

The description may contain procedural or methodical aspects upon describing structural features of the invention; the structural features can be understood well in that way. It is emphasized to the reader that such structural features can be lifted from the described context without hesitation or the question of an intermediate generalization to form aspects of the invention. It is also emphasized to the reader that any the structural features described in the following can be understood as individual aspects of the invention to distinguish from known solutions, despite being possibly lifted from the context.

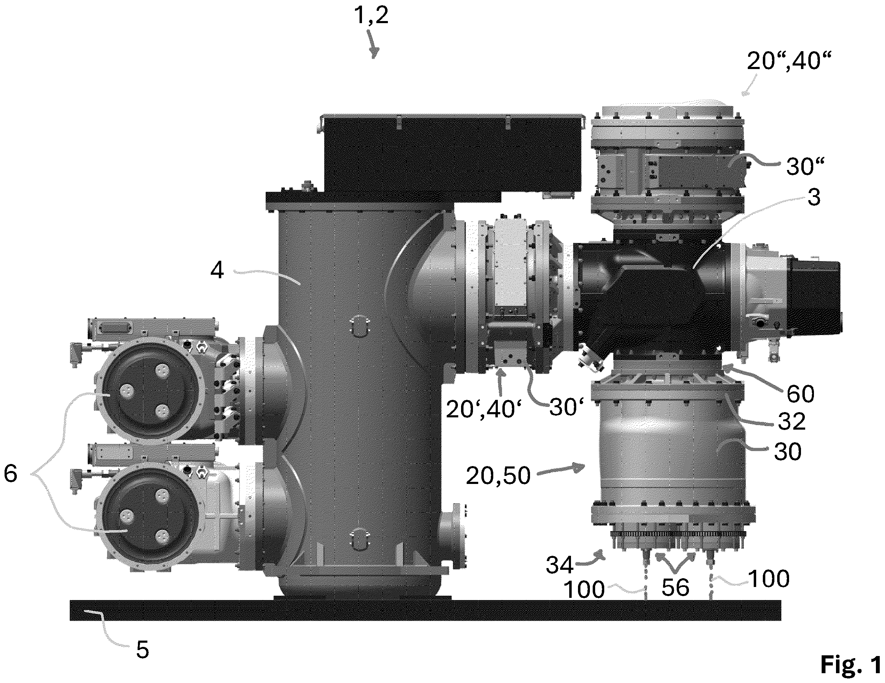

Fig. 1 shows a part of a substation 1 with a gas-insulated switchgear 2. Simply said, the switchgear 2 of Fig. 1 represents a solution which is at least in part according to prior art, e.g. with respect to a number of low-power instrument transformers (LPIT) 40', 40" contained in this switchgear 2, and/or with respect to the LPITs 40', 40" and a cable end module 50 each contained in their own housing 30, 30', 30".

The switchgear 2 of Fig. 1 is filled with insulating gas. The switchgear 2 includes a circuit-breaker 4, an electrical component 3 in the form of a disconnector/earthing switch, two busbars 6 with disconnectors coupled to the circuit-breaker 4, and three systems 20, 20', 20" for a gas-insulated switchgear 2.

One system 20 includes a cable end module 50 arranged in a housing 30 of said system 20, configured for receiving three power lines 100 and connecting the power lines 100 to the electrical component 3 especially through a flange 32 of the housing 30.

Another system 20' includes a low-power instrument transformer 40' arranged in a housing 30' of said system 20' and is coupled between the electrical component 3 and the circuit-breaker 4, particularly by means of flanges of the housing 30'. The housing 30' can provide a mechanical link and/or a gas tight or fluid tight connection between the electrical component 3 and the circuit-breaker 4.

The last system 20" includes a second low-power instrument transformer 40" arranged in a housing 30" of said system 20" and is coupled to the electrical component 3 on a side opposite the cable end module 50, particularly by means of a flange of the housing 30". The system 20" can be arranged above the electrical component 3.

With reference to Fig. 1, the housing 30 of the system 20 has the flange 32 coupled to a connector 60 of the system 20. The connector 60 is coupled to the electrical component 3, especially a flange thereof. Opposite the flange 32 of the housing 30, on a receptacle side 34, the cable end module 50 provides receptacles 56 for receiving the power lines 100.

With reference to Fig. 1, the switchgear 2 has a base 5 or baseframe which supports its components. Typically, the switchgear 2 erects, particularly substantially vertically, from the base 5. Power lines 100 can be guided through and/or substantially perpendicular to the base 5 into the cable end module 50 or cable end unit, CEU for short, of the system 20.

With reference to Fig. 1, voltage and current can be measured by means of the transformers 40', 40". Particularly, for current measuring, the transformer 40' is placed on an exit flange of the circuit-breaker 4. However, once the electrical component 3, i.e. the disconnector/earthing switch, is opened, the transformer 40' cannot be used anymore for voltage measurement on the exit flange. Particularly, the transformer 40" is placed on another side of the electrical component 3 for voltage measurement, especially when the electrical component 3 is open.

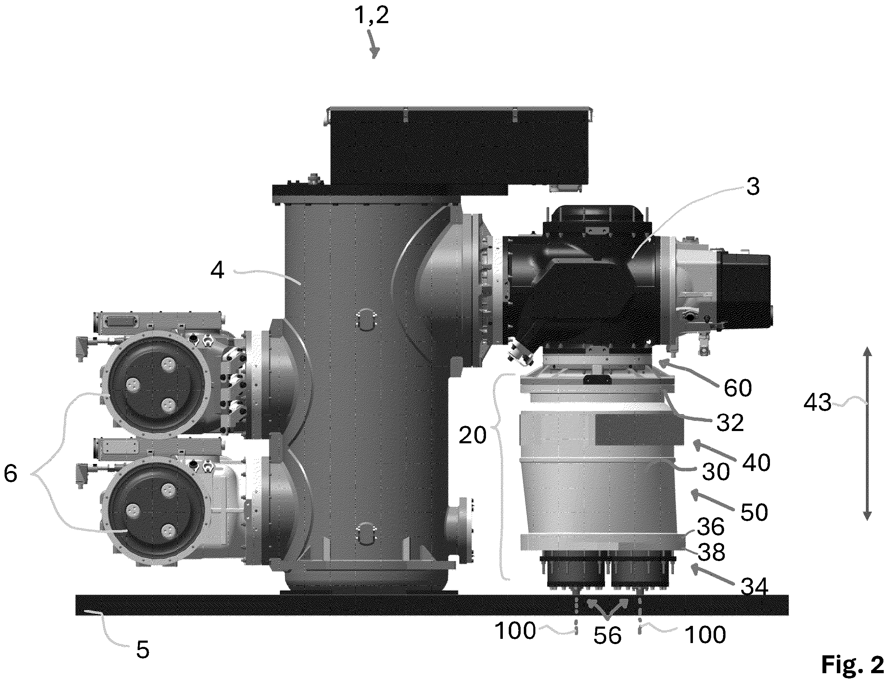

With the switchgear 2 of Fig. 1 in mind, involving two LPITs or transformers 40, 40', directing the view towards Fig. 2, the invention has been developed so that merely a single LPIT or transformer 40 is needed, which is arranged on the side of the electrical component 3 or disconnector/earthing switch facing a cable end module 50. On top of this, the invention is improved by integrating the single transformer 40 in a housing 30 together with the cable end module 50 as one system 20, aiming to reduce a length of the system 20 in comparison to coupling a cable end to a disconnector/earthing switch with an LPIT in between, i.e. involving separate housings and more space needed. Thus, voltage and current may be measured independent from the disconnector/earthing switch being open or closed and space required is reduced.

Fig. 2 shows a part of a substation 1 with a gas-insulated switchgear 2 and with a system 20 for the gas-insulated switchgear 2. The gas-insulated switchgear 2 may be arranged in an offshore windmill park, e.g. with restricted space requirements.

The gas-insulated switchgear 2 of Fig. 2 can be shipped to the location of application in a high cube container or HC container, wherein the switchgear 2 of Fig. 1, due to two LPITs instead of one resulting in greater size and weight, cannot be shipped in a HC container.

The switchgear 2 of Figs. 1 and 2 may have a weight of less than 3500 kg, particularly less than 3000 kg. The switchgear 2 of Fig. 1 has a weight of 2870 kg ± 100 kg. The switchgear 2 of Fig. 2 has a weight of 2590 kg ± 100 kg, i.e. is lighter.

The switchgear 2 of Figs. 1 and 2 may have a length in a direction from busbar 6 towards electrical component 3 of less than 4000 mm, particularly less than 3750 mm. The switchgear 2 of Fig. 1 has a length of 3700 mm ± 100 mm. The switchgear 2 of Fig. 2 has a length of 3320 mm ± 100 mm, i.e. is smaller.

With reference to Fig. 2, particularly, the switchgear 2 includes an electrical component, see reference numeral 3, in the form of a disconnector/earthing switch coupled to another electrical component in the form of a circuit-breaker 4, and two busbars 6 with disconnectors coupled to the circuit-breaker 4. The system 20 is coupled to the electrical component 3, i.e. the disconnector/earthing switch.

The circuit-breaker 4 is coupled to a base 5 of the system 20. The base 5 is substantially flat. Power lines 100 extend substantially perpendicular to the base 5 and particularly through the base 5.

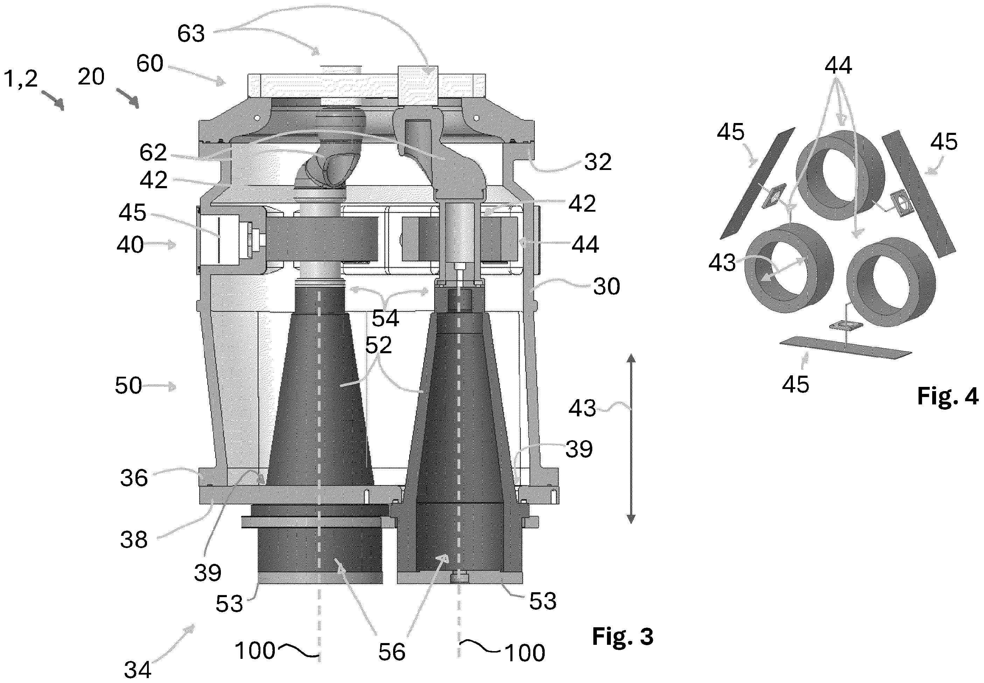

Further, reference is made to Fig. 2 to 4. The system 20 of Fig. 2 is shown in more detail in Fig. 3. Fig. 4 shows components of the transformer 40 of the system 20.

The system 20 comprises a housing 30 with a flange 32 coupled to the electrical component 3, particularly to a flange of the electrical component 3.

Generally, the disconnector/earthing switch to which the system 20 is connected or coupled is an electrical component 3 of the gas-insulated switchgear. The electrical component 3, particularly the disconnector/earthing switch, has a flange coupled at least indirectly to the flange 32 of the system 20 in a fluid tight or gas tight manner.

The system 20 comprises a low-power instrument transformer 40 arranged in the housing 30, including three conductive sections 42 electrically connected through the flange 32 to the electrical component 3 and configured for conducting current and voltage measurements on the three conductive sections 42.

The system 20 comprises a cable end module 50 arranged in the housing 30, receiving three power lines 100 and connecting the three power lines 100 to the three conductive sections 42, wherein each one of the three power lines 100 is connected to one of the three conductive sections 42.

Thus, the three power lines 100 are electrically connected to the electrical component 3 or disconnector/earthing switch. Particularly, the three power lines 100 are electrically connected to the electrical component 3 through the flange 32.

The three conductive sections 42 extend along a first direction 43 inside the housing 30.

The low-power instrument transformer 40 comprises, per conductive section 42, one measurement coil 44 or Rogowski coil surrounding the respective conductive section 42 at least substantially in a plane perpendicular to the first direction 43 and at least substantially in the middle of the at least one conductive section 42 along the first direction 43.

With particular respect to Fig. 4, parts of the low-power instrument transformer 40 are shown. Particularly, the three measurement coils 44 are shown through which the conductive sections 42 can extend. The measurement coils 44 are arranged entirely inside the housing 30. Adjacent to the coils 44, control devices 45 are arranged which are configured to control the measurement coils 44. For example, each control device 45 may control one of the measurement coils 44, particularly may measure current therewith. The control devices 45 may include at least one merging unit. Not shown in detail are capacitive voltage sensors of the low-power instrument transformer 40.

The cable end module 50 connects the three power lines 100 to the three conductive sections 42. The cable end module 50 comprises three isolating bodies 52 coupled to the housing 30, arranged to be in line on a first end 54 with the respective conductive section 42 and providing a receptacle 56 opposite the first end 54 for the respective power line 100 of the three power lines 100.

The cable end module 50 is configured to receive the three power lines 100 in a vertical direction, wherein the flange 32 substantially extends along a horizontal plane.

The housing 30 exhibits a cable receptacle side 34 that provides access to the cable end module 50, particularly to the receptacles 56, for connecting the power lines 100.

The cable receptacle side 34 has a further flange 36 closed by a cover member 38 of the housing 30. The cover member 38 has three recesses 39 through which the cable end module 50, particularly the three isolating bodies 52, is/are accessible. The three power lines 100 can be received through each of the respective recesses 39.

In Fig. 3, the isolating bodies 52 are closed with covers 53 which can be removed to receive the power lines 100. The covers 53 might be transport covers.

The system 20 comprises a connector 60 for mechanical connection. The connector is directly coupled to the flange 32 and directly coupled or to be directly coupled to the electrical component 3. The connector 60 tapers in diameter in the course from the side coupled to the flange 32 to the side to be directly coupled to the electrical component 3.

Each of the three conductive sections 42 is, at least in a section, a hollow cylinder comprising or at least substantially consisting of aluminum.

The system 20 comprises, per each conductive section 42, one or more further conductive sections 62, 63 connected to the respective conductive section 42, e.g. directly or indirectly. Each of the three conductive sections 42 and each of the one or more further conductive sections 62, 63, is/are arranged for electrical connection of the at least one power line 100 to the electrical component 3.

Particularly, the electrical connection from a respective power line 100 to the electrical component 3 is via a conductive section 42 and two further conductive sections 62, 63 arranged in series. The further conductive sections 62, 63 are screwed directly together. The further conductive section 62 and the respective conductive section 42 are screwed directly together.

The conductive sections 42 and the further conductive sections 62, 63 comprise or at least substantially consist of aluminum.

The system 20 is configured as a three-pole system 20 with each of the three power lines 100 corresponding to one of the three poles.

Particularly, electrical components of a/the switchgear 2, for example that of Fig. 2, e.g. the electrical component 3, the circuit-breaker, the system 20, and/or the busbar(s) 6, may at least substantially be arranged in a common plane and/or adjacent to one another with respect to a/the common plane. Particularly, the components of the switchgear 2 are distributed across the common plane, typically in order to provide a compact design. e.g. suitable for transportation in a HC container.

Shown and described is a use of a system 20, a switchgear 2 or a substation 1 in an offshore windmill park. The substation 1, particularly the switchgear 2 with the system 20, may be arranged at least in part on the sea and/or within a range of up to 5 km relative to the offshore windmill park, where space typically is limited.

### Reference signs list

- 1: substation
- 2: gas-insulated switchgear
- 3: electrical component
- 4: circuit-breaker
- 5: base

- 20: system

- 30: housing
- 32: flange
- 34: cable receptacle side
- 36: further flange
- 38: cover member
- 39: recess

- 40: low-power instrument transformer
- 42: conductive section
- 43: first direction
- 44: measurement coil
- 45: control device

- 50: cable end module
- 52: isolating body
- 53: cover
- 54: first end
- 56: receptacle

- 60: connector
- 62: further conductive section
- 63: further conductive section

- 100: power line

## Claims

1. System (20) for a gas-insulated switchgear (2), comprising
a housing (30) with a flange (32) to be coupled to an electrical component (3), e.g. a disconnector/earthing switch, of the gas-insulated switchgear (2);
a low-power instrument transformer (40) arranged in the housing (30) and configured for conducting current and voltage measurements; and
a cable end module (50) arranged in the housing (30) and configured for receiving at least one power line (100) to be electrically connected to the electrical component (3) through the flange (32).

2. System (20) according to the preceding claim, wherein
the low-power instrument transformer (40) includes at least one conductive section (42) that extends along a first direction (43) inside the housing (30) to be electrically connected through the flange (32) to the electrical component (3),
the low-power instrument transformer (40) comprises at least one measurement coil (44) surrounding the at least one conductive section (42) in a plane perpendicular to the first direction (43) and, optionally, at least substantially in the middle of the at least one conductive section (42) along the first direction (43).

3. System (20) according to the preceding claim, wherein
the cable end module (50) connects the at least one power line (100) to the at least one conductive section (42) and comprises at least one isolating body (52) coupled to the housing (30), arranged to be in line on a first end (54) with the at least one conductive section (42) and configured to provide a receptacle (56) opposite the first end (54) for the at least one power line (100).

4. System (20) according to any one of the preceding claims, wherein
the cable end module (50) is configured to receive the at least one power line (100) in a vertical direction, wherein the flange (32) substantially extends along a horizontal plane.

5. System (20) according to any one of the preceding claims, wherein
the housing (30) exhibits a cable receptacle side (34), and
the cable receptacle side (34) provides access to the cable end module (50), particularly to the receptacle (56), for connecting the at least one power line (100).

6. System (20) according to the preceding claim, wherein
the cable receptacle side (34) has a further flange (36) closed by a cover member (38) of the housing (30), and
the cover member (38) has at least one recess (39) through which the cable end module (50) is accessible for receiving the at least one power line (100).

7. System (20) according to any one of the preceding claims, comprising
a connector (60) for mechanical connection, directly coupled to the flange (32) and configured to be directly coupled to the electrical component (3),
wherein the connector (60) tapers in diameter in the course from the side coupled to the flange (32) to the side to be directly coupled to the electrical component (3).

8. System (20) according to any one of the preceding six claims, wherein
the at least one conductive section (42) is, at least in a section, a hollow cylinder comprising or at least substantially consisting of an aluminum alloy.

9. System (20) according to any one of the preceding seven claims, wherein
the at least one conductive section (42), and optionally at least one further conductive section (62, 63) of the system (20) connected to the at least one conductive section (42), is/are arranged for electrical connection of the at least one power line (100) to the electrical component (3).

10. System (20) according to the preceding claim, wherein
the at least one further conductive section (62, 63) and the at least one conductive section (42) are screwed directly together.

11. System (20) according to any one of the preceding two claims, wherein
the at least one conductive section (42) and the at least one further conductive section (62, 63) comprise or at least substantially consist of an aluminum alloy.

12. System (20) according to any one of the preceding claims, configured as a three-pole system (20) with the at least one power line (100) comprising three power lines each corresponding to one of the three poles.

13. Gas-insulated switchgear (2) comprising
an electrical component (3), e.g. a disconnector/earthing switch;
a circuit-breaker (4) connected to the electrical component (3); and
a system (20) according to any one of the preceding claims; wherein
the system (20) is connected to the electrical component (3).

14. Substation (1) comprising a gas-insulated switchgear (2) according to the preceding claim.

15. Use of a system (20) according to one of claims 1 to 12, of a gas-insulated switchgear (2) according to claim 13, or of a substation (1) according to claim 14 in an offshore windmill park.
